(19) Europäisches Patentamt
European Patent Office
Office européen des brevets

(11) EP 2 634 777 A1

(12) EUROPEAN PATENT APPLICATION
published in accordance with Art. 153(4) EPC

(43) Date of publication:
04.09.2013 Bulletin 2013/36

(51) Int Cl.:
H01B 5/14 (2006.01)    H01B 13/00 (2006.01)
H01L 31/04 (2006.01)    H01M 14/00 (2006.01)

(21) Application number: 11835780.5

(22) Date of filing: 07.10.2011

(86) International application number:
PCT/JP2011/005646

(87) International publication number:
WO 2012/056632 (03.05.2012 Gazette 2012/18)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(30) Priority: 25.10.2010 JP 2010238157

(71) Applicant: Sony Corporation
Tokyo 108-0075 (JP)

(72) Inventors:
• SHIMIZU, Keisuke
  Tokyo 108-0075 (JP)
• KOBAYASHI, Toshiyuki
  Tokyo 108-0075 (JP)

(74) Representative: Müller - Hoffmann & Partner
Patentanwälte
Innere Wiener Strasse 17
81667 München (DE)

(54) TRANSPARENT ELECTRICALLY CONDUCTIVE FILM, METHOD FOR MANUFACTURING TRANSPARENT ELECTRICALLY CONDUCTIVE FILM, PHOTOELECTRIC CONVERSION DEVICE AND ELECTRONIC EQUIPMENT

(57)    [Object] To provide a transparent conductive film that has sufficiently low sheet resistance and a sufficiently high visible light transmittance, is capable of securing high conductivity on an entire surface thereof, and has excellent corrosion resistance to an electrolyte solution, a method of producing the transparent conductive film, and a photoelectric conversion apparatus and an electronic apparatus using the transparent conductive film.

[Solving Means] A transparent conductive film includes a metal fine line network layer 12 and one or more layers of graphene layers 13 provided on at least one surface of the metal fine line network layer 12. The metal fine line network layer 12 includes at least one metal selected from a group consisting of copper, silver, aluminum, gold, iron, nickel, titanium, and platinum. The metal fine line network layer 12 is provided on a transparent substrate 11. In order to achieve a flexible transparent conductive film, a transparent plastic substrate is used as the transparent substrate 11.

FIG.1

EP 2 634 777 A1

**Description**

Technical Field

The present technology relates to a transparent conductive film, a method of producing the transparent conductive film, a photoelectric conversion apparatus, and an electronic apparatus, and is suitable for use in a transparent conductive film that is used for a display, a touch panel, a dye-sensitized solar cell, and the like.

Background Art

In order to increase the area of a display, to make a solar cell more efficient, to make a touch panel more large and fine, and the like, there is a need for a transparent conductive film with low sheet resistance. At present, there are three main structures, which are used for a transparent conductive film with low resistance or a transparent conductive sheet.

The first of these is a transparent oxide thin film typified by an indium-tin oxide (ITO). The transparent oxide thin film needs to be formed by means of a sputtering method. Therefore, there is a problem in that not only the installation cost of a sputtering apparatus is high but also the takt time is long.

The second of these is a metal fine line network layer such as copper and silver. The metal fine line network layer is capable of having lower resistance while securing a high light transmittance. However, there are problems in that it is impossible to secure conductivity in portions other than the metal fine line portion, and the metal fine line portion is easily corroded if the metal fine line portion is directly brought into contact with, for example, an electrolyte solution including iodine and the like.

The third of these is a two layer laminated structure of a metal fine line network layer and a transparent conductive film (see Patent Document 1). In the structure, as a transparent conductive film, various materials are examined. However, in a case where a two-dimensional material such as a carbon nanotube and a metal nanowire is used as a transparent conductive film (e.g., see Patent Document 2), it is difficult to completely coat the metal fine line network layer while maintaining high transparency. This causes a problem of corrosion due to an electrolyte solution. Moreover, in a case where a conductive polymer is used as a transparent conductive film (e.g., see Patent Document 3), the transmittance is significantly decreased because the transparency of the conductive polymer itself is low. Although the most promising transparent conductive film is an oxide thin film including ITO or the like, the oxide thin film has various problems. First, because film formation by means of a sputtering method is needed to produce a transparent conductive film with high quality, it takes a lot of cost inevitably. Second, because a transparent conductive film includes oxide, it has less flexibility and it is difficult to apply it to a flexible substrate and the like. Third, for example, because ITO with high conductivity has less thermal stability and less corrosion resistance, it cannot be used for a transparent conductive film such as a dye-sensitized solar cell. Fourth, it is difficult for a transparent oxide thin film to satisfy conditions such as corrosion resistance, transparent conductivity, flexibility, and simplicity of a manufacturing process, in view of its structure.

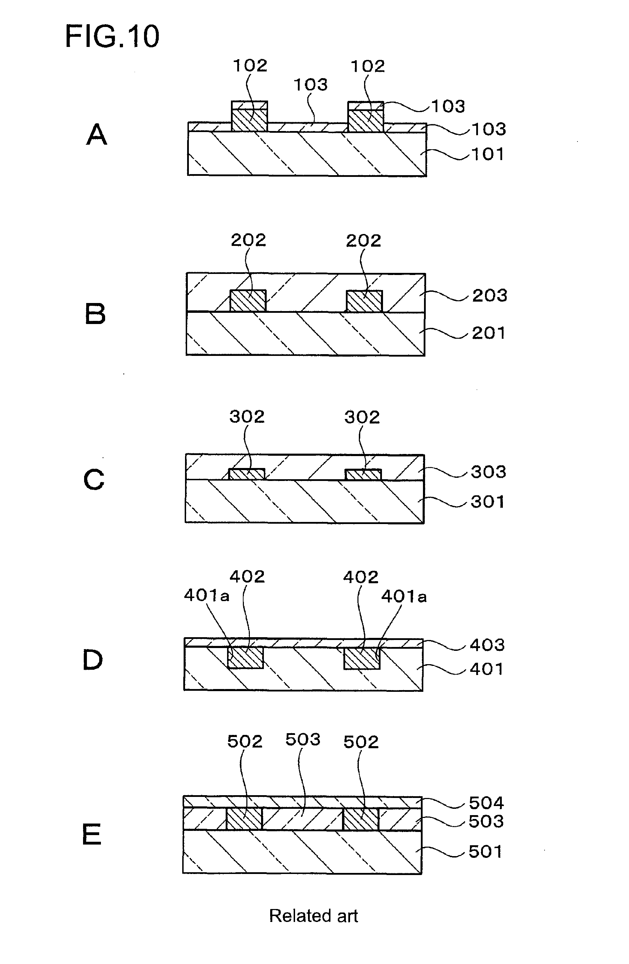

The above-mentioned fourth problem will be described in detail.
In a first related art, as shown in Fig. 10A, after forming metal fine line network layers 102 on a transparent substrate 101, a thin oxide thin film 103 is formed on surfaces of the transparent substrate 101 between the metal fine line network layers 102 and on upper surfaces of the metal fine line network layers 102. The thickness of the metal fine line network layers 102 is about several μm to 10 μm.

In a second related art, as shown in Fig. 10B, after forming metal fine line network layers 202 on a transparent substrate 201, a thick oxide thin film 203 is formed so as to completely cover the metal fine line network layers 202.

In a third related art, as shown in Fig. 10C, after thinly forming metal fine line network layers 302 so as to have a thickness of several hundred nm on a transparent substrate 301, a thin oxide thin film 303 is formed so as to completely cover the metal fine line network layers 302.

In a fourth related art, as shown in Fig. 10D, after forming trenches 401a on a main surface of a transparent substrate 401 and embedding metal fine line network layers 402 in the trenches 401a, a thin oxide thin film 403 is formed so as to cover the metal fine line network layers 402.

In a fifth related art, as shown in Fig. 10E, after forming metal fine line network layers 502 on a transparent substrate 501 and embedding transparent polymer materials 503 in spaces between the metal fine line network layers 502, a thin oxide thin film 504 is formed on the metal fine line network layers 502 and the transparent polymer materials 503.

Citation List

Patent Document

Patent Document 1: Japanese Patent Application Laid-open No. 2009-4726
Patent Document 2: Japanese Patent Application Laid-open No. 2009-252493
Patent Document 3: Japanese Patent Application Laid-open No. 2009-231194
Patent Document 4: Japanese Patent Application Laid-open No. 2009-21342
Patent Document 5: Japanese Patent Application Laid-open No. 2005-108467
Patent Document 6: Japanese Patent Application Laid-open No. 2005-332705
Patent Document 7: Japanese Patent Application Laid-open No. 2008-288102

Non-Patent Document

Non-Patent Document 1: Nano Letters 2009,9,4359

Disclosure of the Invention

Problem to be solved by the Invention

However, in the first related art, the metal fine line network layer 102 is easily corroded in a case where it is used in an environment in which an electrolyte solution including iodine or the like is brought into contact with it, because the side surface of the metal fine line network layer 102 is exposed. Moreover, if a transparent conductive film is bent, the oxide thin film 103 is easily peeled off from the metal fine line network layer 102.

In the second related art, it is difficult to use the thick oxide thin film 203 as a transparent conductive film, because it absorbs most light. For example, in a case where the oxide thin film 203 is an ITO thin film, it absorbs most light when being formed to have a thickness of several $\mu$m or more so as to completely cover the metal fine line network layer 202, because an ITO thin film has a low light transmittance of 70 to 80% even if its thickness is only 200 nm.

In the third related art, the metal fine line network layer 302 has a thin thickness of several hundred nm, which increases electrical resistance.

In the fourth related art, the transparent substrate 401 is limited to a plastic substrate, because the metal fine line network layer 402 is embedded in the trench 401a of the transparent substrate 401. Moreover, there is a need to form the trench 401a in the transparent substrate 401, which makes the manufacturing process for a transparent conductive film more complicated. Furthermore, if a transparent conductive film is bent, the oxide thin film 403 is easily peeled off from the transparent substrate 401 and the metal fine line network layer 402.

In the fifth related art, the metal fine line network layer 502 is embedded with the transparent polymer material 503, which decreases the transparent conductivity, and makes the manufacturing process more complicated. Moreover, if a transparent conductive film is bent, the oxide thin film 504 is easily peeled off from the metal fine line network layer 502 and the transparent polymer material 503.
As described above, any of the existing transparent conductive films has advantages and disadvantages.

In view of the above, the problem to be solved by the technology is to provide a transparent conductive film that has sufficiently low sheet resistance and a sufficiently high visible light transmittance, is capable of securing high conductivity on an entire surface thereof, and has excellent corrosion resistance to an electrolyte solution.
Another problem to be solved by the technology is to provide a method of producing a transparent conductive film that is capable of easily producing the excellent transparent conductive film described above at low costs.

Still another problem to be solved by the technology is to provide a photoelectric conversion apparatus with high performance and an electronic apparatus with high performance, which include the excellent transparent conductive film described above.
The above and other problems will become apparent from the description of the specification.

Means for solving the Problem

In order to solve the problems described above, the present technology is a transparent conductive film that includes a metal fine line network layer and one or more layers of graphene layers provided on at least one surface of the metal fine line network layer.

In the transparent conductive film, the graphene layer may be provided on both surfaces of the metal fine line network layer. In the transparent conductive film, typically, the metal fine line network layer is provided on a transparent substrate, and the graphene layer is provided on the metal fine line network layer. However, the metal fine line network layer and the graphene layer may be laminated in the reverse order. That is, in the transparent conductive film, the graphene layer may be provided on the transparent substrate, and the metal fine line network layer may be provided on the graphene layer. The material of the transparent substrate is selected as necessary. However, in order to achieve a flexible transparent conductive film, it is favorable to use a transparent plastic substrate as the transparent substrate.

The material of the metal fine line network layer is selected as necessary. However, the material is, for example, pure metal or an alloy including at least one metal selected from a group consisting of copper (Cu), silver (Ag), aluminum (Al), gold (Au), iron (Fe), nickel (Ni), titanium (Ti), and platinum (Pt). As necessary, a surface of the metal fine line network layer may be blackened to prevent light from reflecting on the surface of the metal fine line network layer (e.g., see Patent Document 4).

The sheet resistance of the graphene layer constituting the transparent conductive film is equal to or less than 500 $\Omega$/sq, and the sheet resistance of the transparent conductive film is favorably equal to or higher than 0.01 $\Omega$/sq and equal to or less than 10 $\Omega$/sq. However, it is not limited thereto. The light transmittance of the transparent conductive film at a wavelength of 550 nm is favorably equal to or greater than 70%. However, it is not limited thereto. Moreover, the smoothness (concavity and convexity) of a conductive surface of the transparent conductive film is favorably greater than 5 $\mu$m. The conductive surface of the transparent conductive film is a surface of the graphene layer in a case where the surface of the graphene layer of the transparent conductive film is exposed, and a surface of the metal fine line network layer in a case where the surface of the metal fine line network layer of the transparent conductive film is exposed. The smoothness (concavity and convexity) of the conductive surface of the transparent conductive film represents an average amplitude of a concavo-convex portion when an area of 5 mm square is measured by using a three-dimensional surface roughness meter.

The transparent conductive film can be used as a transparent conductive film or a transparent conductive sheet.

Moreover, the present technology is a method of producing a transparent conductive film, the method including the steps of:

    forming one or more layers of graphene layers on a first substrate including metal;
    bonding a side of the graphene layer of the first substrate to a second substrate;
    removing the first substrate;
    bonding a side of the graphene layer of the second substrate to a metal fine line network layer formed on a transparent substrate; and
    removing the second substrate.

Here, in a case where one or more layers of graphene layers are formed on a transparent substrate, and where a metal fine line network layer is formed on the graphene layer, a transparent conductive film in which graphene layers are provided on both surface of the metal fine line network layer can be produced.

Moreover, the present technology is a method of producing a transparent conductive film, the method including the steps of:

    forming one or more layers of graphene layers on a first substrate including metal;
    bonding a side of the graphene layer of the first substrate to a second substrate;
    forming a metal fine line network layer by patterning the first substrate;
    bonding a side of the metal fine line network layer of the second substrate to a transparent substrate; and
    removing the second substrate.

Moreover, the present technology is a method of producing a transparent conductive film, the method including the steps of:

    forming one or more layers of graphene layers on a first substrate including metal;
    bonding a side of the graphene layer of the first substrate to a metal fine line network layer formed on a transparent substrate; and
    removing the first substrate.

Moreover, the present technology is a method of producing a transparent conductive film, the method including the steps of:

    forming one or more layers of graphene layers on a first substrate including metal;
    bonding a side of the graphene layer of the first substrate to a transparent substrate; and
    forming a metal fine line network layer by patterning the first substrate.

Here, the method of producing a transparent conductive film may further include the steps of bonding one or more layers of graphene layers formed on a second substrate to the metal fine line network layer after forming the metal fine line network layer and removing the second substrate. Thus, a transparent conductive film in which graphene layers are provided on both surface of the metal fine line network layer can be produced.

The method of producing a transparent conductive film according to the technology described above is capable of easily producing a transparent conductive film according to the present technology. The first substrate including metal includes, for example, at least one metal selected from a group consisting of aluminum (Al), silicon (Si), titanium (Ti), vanadium (V), chromium (Cr), manganese (Mn), iron (Fe), cobalt (Co), nickel (Ni), copper (Cu), molybdenum (Mo), platinum (Pt), silver (Ag), gold (Au), and tungsten (W). The first substrate favorably includes copper from a view point of forming a grapheme layer with high quality, and includes a copper foil, for example. The second substrate has, for example, a structure including, as a supporting body, polymethyl methacrylate (PMMA), polydimethylsiloxane (PDMS), and a thermal release tape, and, if they are not strong enough themselves, a glass substrate, a polymer substrate, and the like in addition thereto. In a case where a flexible transparent conductive film is produced, typically, a transparent plastic substrate is used as a transparent substrate. Other than those described above, it is the same as the transparent conductive film according to the present technology.

Moreover, the present technology is a photoelectric conversion apparatus having a structure in which an electrolyte layer is filled between a porous photoelectrode and a counter electrode provided on a transparent substrate through a transparent conductive film, the transparent conductive film including a metal fine line network layer and one or more layers of graphene layers provided on at least one surface of the metal fine line network layer.

The photoelectric conversion apparatus is typically a dye-sensitized photoelectric conversion apparatus, but it is not limited to this. The photoelectric conversion apparatus can be any apparatus as long as it uses a transparent conductive film. The porous photoelectrode typically includes semiconductor particles, and the dye-sensitized photoelectric conversion apparatus causes the semiconductor particles to support a photosensitizing dye. A porous photoelectrode including particles with so-called core-shell structure may be used as the porous photoelectrode. In this case, it does not necessarily have to bond the photosensitizing dye. The particles with core-shell structure specifically include a core, which includes metal oxide, and a shell, which includes metal that surrounds the core. Alternatively, the particles with core-shell structure include a core, which includes metal, and a shell, which includes metal oxide that surrounds the core. As the metal oxide, favorably, at least one metal oxide selected from a group consisting of titanium oxide ($TiO_2$), tin oxide ($SnO_2$), niobium oxide ($Nb_2O_5$), and zinc oxide (ZnO) is used. Moreover, as the metal, for example, gold, silver, or copper is used. The particle size of metal/metal oxide particles is selected appropriately, but it is favorably 1 to 500 nm. Moreover, also the particles size of the core of the metal/metal oxide particles is selected appropriately, but it is favorably 1 to 200 nm.

Moreover, the present technology is an electronic apparatus including a transparent conductive film that includes a metal fine line network layer and one or more layers of graphene layers provided on at least one surface of the metal fine line network layer.

Here, various electronic apparatuses may be used as long as they use a transparent conductive film. Specifically, the electronic apparatus is, for example, a display such as a liquid crystal display (LCD) and an organic electroluminescence display, or a touch panel, and the transparent conductive film may be used for any purpose.

In the present technology configured as described above, the graphene layer has excellent properties such as significantly low volume resistivity, high transparent conductivity, high intensity, high barrier properties, and high corrosion resistance. Therefore, because the transparent conductive film includes a metal fine line network layer and one or more layers of graphene layers provided on at least one surface of the metal fine line network layer, it is possible to achieve a transparent conductive film with high transparent conductivity that has sufficiently low sheet resistance and a sufficiently high visible light transmittance. Moreover, in a case where the transparent conductive film is used in an environment in which a corrosive material such as an electrolyte solution exists, it is possible to achieve excellent corrosion resistance to an electrolyte solution by bringing a side of the graphene layer of the transparent conductive film into contact with the electrolyte solution. Moreover, it is possible to secure high conductivity on an entire surface of the transparent conductive film including an opening of the metal fine line network layer, because the entire metal fine line network layer is covered by the graphene layer with excellent transparent conductivity. Moreover, in the method of producing a transparent conductive film, it is possible to produce the excellent transparent conductive film described above by only using a simple established existing technology.

Effect of the Invention

According to the present technology, it is possible to achieve a transparent conductive film that has sufficiently low sheet resistance and a sufficiently high visible light transmittance, is capable of securing high conductivity on an entire surface thereof, and has excellent corrosion resistance to an electrolyte solution. Moreover, it is possible to easily produce such a transparent conductive film at low costs. Moreover, by using the transparent conductive film as, for example, a transparent conductive film of a photoelectric conversion apparatus that uses an electrolyte solution, such as a dye-sensitized photoelectric conversion apparatus, it is possible to improve corrosion resistance to an electrolyte solution of the transparent conductive film, which improves the life-span of the photoelectric conversion apparatus. Moreover, it is possible to achieve a photoelectric conversion apparatus with high performance. Furthermore, by using the transparent conductive film as a transparent conductive film of an electronic apparatus, it is possible to achieve an electronic apparatus with high performance.

Brief Description of Drawings

[Figs. 1] A cross-sectional view and a plan view showing a transparent conductive film according to a first embodiment of the present technology.
[Figs. 2] A cross-sectional view for explaining a first example of a method of producing a transparent conductive film according to the first embodiment of the present technology.
[Figs. 3] A cross-sectional view for explaining the first example of the method of producing a transparent conductive film according to the first embodiment of the present technology.
[Figs. 4] A cross-sectional view for explaining a second example of the method of producing a transparent conductive film according to the first embodiment of the present technology.
[Figs. 5] A cross-sectional view for explaining a third example of the method of producing a transparent conductive film according to the first embodiment of the present technology.
[Figs. 6] A cross-sectional view for explaining a method of producing a transparent conductive film according to a second embodiment of the present technology.
[Fig. 7] A cross-sectional view showing a transparent conductive film according to a third embodiment of the present technology.
[Figs. 8] A cross-sectional view for explaining a method of producing a transparent conductive film according to the third embodiment of the present technology.
[Fig. 9] A cross-sectional view showing a dye-sensitized photoelectric conversion apparatus according to a fourth embodiment of the present technology.
[Figs. 10] A cross-sectional view showing an existing transparent conductive film.

Best Mode(s) for Carrying Out the Invention

Hereinafter, embodiments for carrying out the present technology (hereinafter, referred to as "embodiments") will be described. It should be noted that a description will be given in the following order.

1. First Embodiment (transparent conductive film and method of producing the same)
2. Second Embodiment (transparent conductive film and method of producing the same)
3. Third embodiment (transparent conductive film and method of producing the same)
4. Fourth Embodiment (dye-sensitized photoelectric conversion apparatus and method of producing the same)

<1. First Embodiment>

[Transparent Conductive Film]

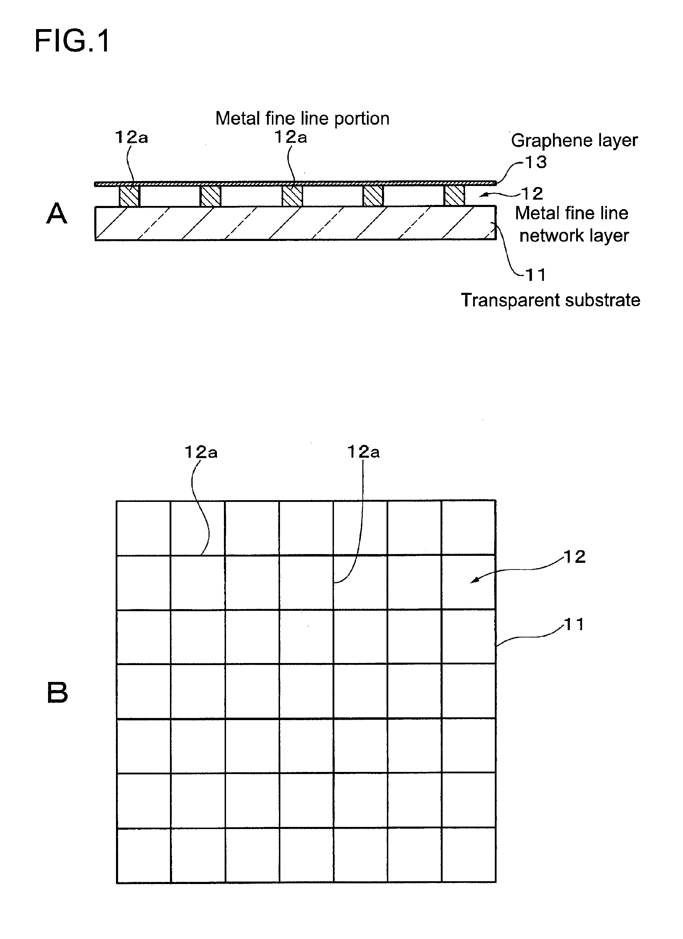

As shown in Fig. 1A, in the transparent conductive film according to a first embodiment, metal fine line network layers 12 are provided on a transparent substrate 11, and one or more layers of graphene layers 13 are provided on the metal fine line network layers 12. The metal fine line network layers 12 are completely covered by the graphene layer 13.
The transparent substrate 11 does not need to be flexible. The material of the transparent substrate 11 is appropriately selected depending on the intended use of the transparent conductive film and the like, and examples of the material include a transparent inorganic material such as quartz and glass and transparent plastic. As the flexible transparent substrate 11, a transparent plastic substrate is used. Examples of transparent plastic include polyethylene terephthalate, polyethylene naphthalate, polycarbonate, polystyrene, polyethylene, polypropylene, polyphenylene sulfide, polyvinylidene difluoride, acetylcellulose, brominated phenoxy, aramids, polyimides, polystyrenes, polyarylates, polysulfones, and polyolefins. The thickness of the transparent substrate 11 is appropriately selected depending on the intended use of the transparent conductive film and the like.
The metal fine line network layer 12 is, for example, pure metal or an alloy including at least one metal selected from a group consisting of Cu, Ag, Al, Au, Fe, Ni, Ti, and Pt. However, other metal may be used for the metal fine line network layer 12. The thickness of the metal fine line network layer 12 is selected as necessary. However, it is equal to or larger than 3 $\mu$m and equal to or larger than 15 $\mu$m, typically, equal to or larger than 5 $\mu$m and equal to or smaller than 12 $\mu$m, for example. The metal fine line network layer 12 is favorably formed so that the sheet resistance of the entire transparent conductive film is equal to or higher than 0.01 $\Omega$/sq and equal to or less than 10 $\Omega$/sq, and the light transmittance of the entire transparent conductive film at a wavelength of 550 nm is equal to or greater than 70%. Favorably, the metal fine line network layer 12 is formed so that the sheet resistance of the entire transparent conductive film is equal to or higher than 0.01 $\Omega$/sq and equal to or less than 10 $\Omega$/sq, and the visible light transmittance of the entire transparent conductive film is equal to or larger than 75%. Specifically, the kind of metal constituting the metal fine line network layer 12, the width, thickness, and pitch of a metal fine line portion 12a, the network shape, the aperture ratio, and the like are determined so that these characteristics are achieved. The width of the metal fine line portion 12a of the metal fine line network layer 12 is, for example, equal to or larger than 5 $\mu$m and 50 $\mu$m, the thickness of the metal fine line portion 12a is, for example, equal to or larger than 3 $\mu$m and equal to or smaller than 15 $\mu$m, and the pitch of the metal fine line portion 12a is, for example, equal to or larger than 50 $\mu$m and equal to or smaller than 1 cm. The network shape of the metal fine line network layer 12 is selected as necessary. However, one example of the network shape is a lattice shape as shown in Fig. 1B.

The graphene layer 13 may include one or more layers. However, the number of layers of the graphene layer 13 is appropriately determined depending on the transmittance that is needed for the transparent conductive film, because the visible light transmittance is decreased by 2.3% for each additional layer.

[Method of Producing Transparent Conductive Film]

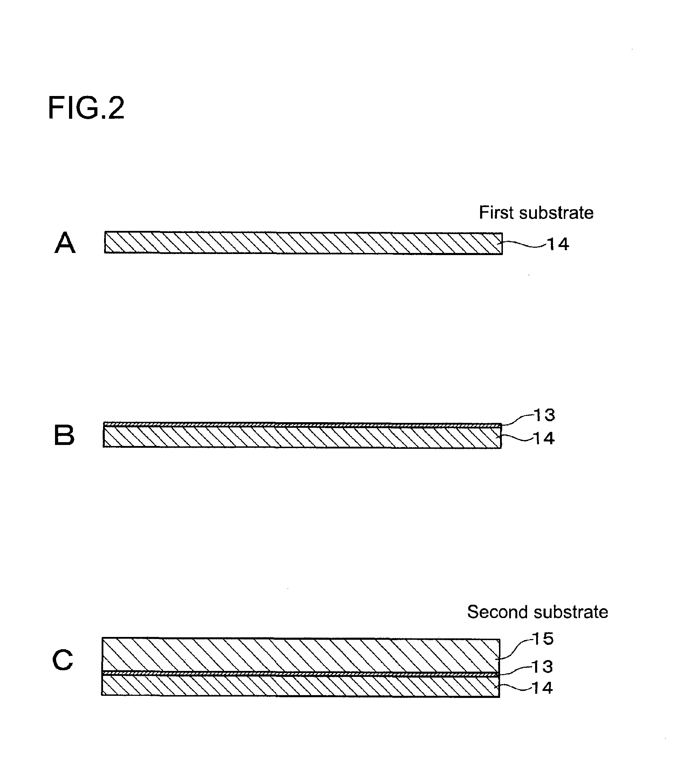

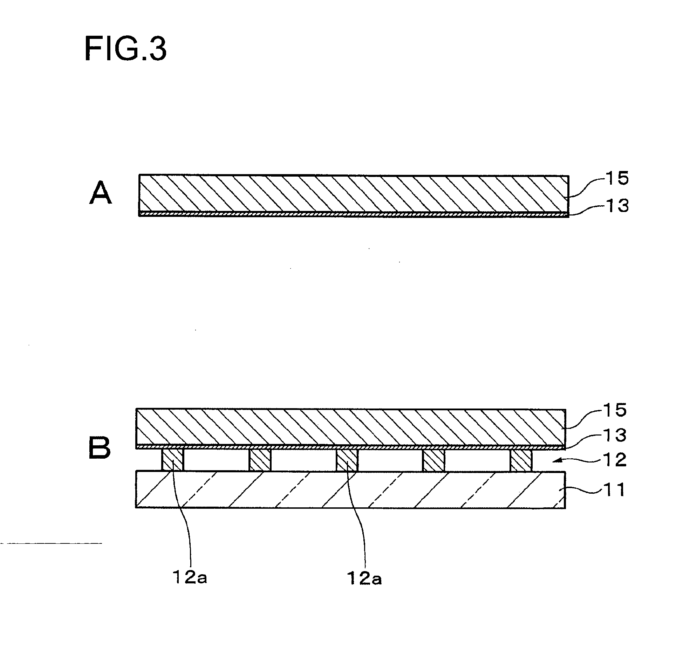

Figs. 2A to 2C and Figs. 3A and 3B show a first example of a method of producing the transparent conductive film. As shown in Fig. 2A, a first substrate 14 including metal for forming a graphene layer is prepared. The first substrate 14 favorably includes copper, but it is not limited to this.
Next, as shown in Fig. 2B, one or more layers of graphene layers 13 are formed on the first substrate 14. The graphene layer 13 can be formed by using a CVD method, for example.

Next, as shown in Fig. 2C, a side of the graphene layer 13 of the first substrate 14 is bonded to a second substrate 15. The second substrate 15 includes, for example, polydimethylsiloxane (PDMS)/polyethylene terephthalate (PET), and a thermal release tape, but it is not limited to this.

Next, as shown in Fig. 3A, the first substrate 14 is removed. In a case where the first substrate 14 includes copper, for example, it is possible to remove the first substrate 14 by etching it with a ferric nitrate solution or a ferric chloride solution, or performing electrolytic etching on it in a copper sulfate solution, for example.

Next, as shown in Fig. 3B, a side of the graphene layer 13 of the second substrate 15 shown in Fig. 3A is bonded to the metal fine line network layer 12 formed on the transparent substrate 11, which is prepared in advance. This bonding can be performed by, for example, hot-pressing of the metal fine line network layer 12 on the transparent substrate 11 and the graphene layer 13 of the second substrate 15.

After that, in a case where the second substrate 15 includes, for example, PDMS/PET, the second substrate 15 is peeled off as it is, and in a case where the second substrate 15 includes, for example, a thermal release tape, the second substrate 15 is peeled off from the graphene layer 13 by being heated to a temperature at which the thermal release tape is peeled off.
Accordingly, as shown in Fig. 1A, an intended transparent conductive film is produced.

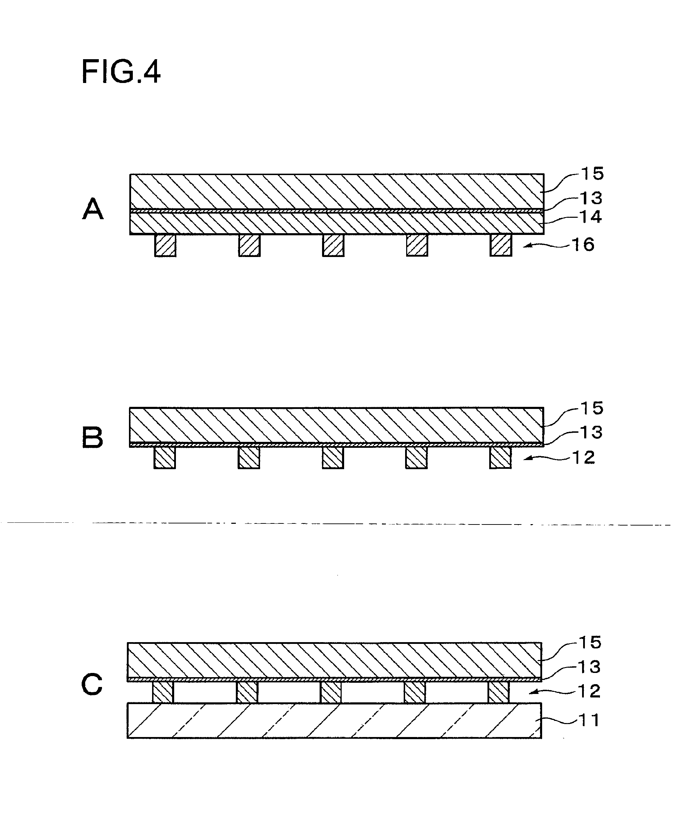

Figs. 4A to 4C show a second example of the method of producing a transparent conductive film. After performing processes to a process shown in Fig. 2C, similarly to the producing method according to the first example, as shown in Fig. 4A, an etching protection film 16 having a network shape corresponding to the metal fine line network layer 12 that should be formed on the first substrate 14 is formed. In this case, as the first substrate 14, a Cu substrate is used. The etching protection film 16 can be formed by, for example, applying photoresist to an entire surface of the first substrate 14 and exposing the photoresist by using a predetermined photo mask before developing it. Moreover, the etching protection film 16 can be formed also by printing a material to be an etching protection film on the first substrate 14 by means of printing techniques.

Next, as shown in Fig. 4B, after the metal fine line network layer 12 including Cu is formed by etching the first substrate 14 with the etching protection film 16 as a mask, the etching protection film 16 is removed.

Next, as shown in Fig. 4C, a side of the metal fine line network layer 12 of the second substrate 15 is bonded to the transparent substrate 11. This bonding can be performed by, for example, hot-pressing of the transparent substrate 11 and the metal fine line network layer 12 of the second substrate 15.

After that, the second substrate 15 is peeled off from the graphene layer 13.
Accordingly, as shown in Fig. 1A, an intended transparent conductive film is produced.

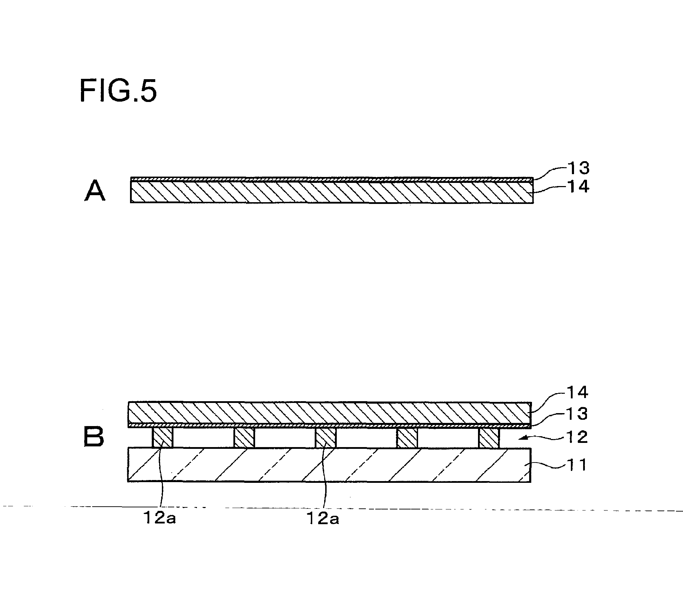

Figs. 5A and 5B show a third example of the method of producing a transparent conductive film. As shown in Fig. 5A, similarly to the first embodiment, one or more layers of graphene layers 13 are formed on the first substrate 14.

Next, as shown in Fig. 5B, a side of the graphene layer 13 of the first substrate 14 shown in Fig. 5A is bonded to the metal fine line network layer 12 formed on the transparent substrate 11, which is prepared in advance.

Next, the first substrate 14 is removed.

Accordingly, as shown in Fig. 1A, an intended transparent conductive film is produced.

<Example 1>

As the first substrate 14, an electrolytic copper foil (manufactured by Furukawa Electric Co., Ltd.), which was processed to have a size of 10 cm x 10 cm, and which had a thickness of 9 μm, was used.

On the electrolytic copper foil, a graphene layer was formed in the same way as that of Non-Patent Document 1. That is, the electrolytic copper foil is placed in a tube furnace of a CVD apparatus, and it is held for 30 minutes at 1000°C under a flow of a hydrogen gas. After that, a graphene layer is caused to grow on the electrolytic copper foil for 15 minutes under a flow of a mixed gas of methane and hydrogen. After the growth of the graphene layer, the temperature is decreased under a flow of a hydrogen gas again. After that, the electrolytic copper foil on which a graphene layer is caused to grow is taken out from the tube furnace.

Next, as the second substrate 15, a PDMS/PET film was used, and the PDMS/PET film was bonded to the graphene layer on the electrolytic copper foil to be used as a supporting body.

Next, as the etching protection film 16, a resist pattern is formed by applying photoresist to the electrolytic copper foil and exposing the photoresist by using a photo mask before developing it.

Next, after patterning the electrolytic copper foil by performing electrolytic etching in a copper sulfate solution with the resist pattern as a mask, the resist pattern is removed. Thus, a metal fine line network layer including copper was formed. The metal fine line network layer has a square lattice shape, and the width, pitch, and thickness of a metal fine line portion is 9 μm, 300 μm, and 10 μm, respectively.

Next, as the transparent substrate 11, a PET substrate is used, and the PET substrate is bonded to a metal fine line network layer on a PDMS/PET film by hot-pressing. After that, the PDMS/PET film is peeled off from the metal fine line network layer.

Accordingly, a transparent conductive film in which a metal fine line network layer including copper was formed on a PET substrate, and a graphene layer was formed thereon was formed.

<Example 2>

A transparent conductive film was produced in the same way as that of Example 1 except that the pitch, width, and thickness of a metal fine line portion of a metal fine line network layer were 600 μm , 9 μm, and 10 μm, respectively.

<Example 3>

A transparent conductive film was produced in the same way as that of Example 1 except that the pitch, width, and thickness of a metal fine line portion of a metal fine line network layer were 250 μm, 20 μm, and 12 μm, respectively.

<Comparative Example 1>

A transparent conductive film according to Comparative Example 1 is a transparent conductive film according to Example 1 of Patent Document 5, and is a transparent conductive film in which an ITO layer is formed on a metal fine line network layer including copper. The pitch, width, and thickness of a metal fine line portion of a metal fine line network layer are 300 μm, 9 μm, and 10 μm, respectively.

<Comparative Example 2>

A transparent conductive film according to Comparative Example 2 is a transparent conductive film according to Example 2 of Patent Document 5, and is a transparent conductive film in which an ITO layer is formed on a metal fine line network layer including copper. The pitch, width, and thickness of a metal fine line portion of a metal fine line network layer are 600 μm, 9 μm, and 10 μm, respectively.

<Comparative Example 3>

A transparent conductive film according to Comparative Example 3 is a transparent conductive film according to Example 1 of Patent Document 6, and is a transparent conductive film in which an ITO layer is formed on a metal fine line network layer including copper. The pitch, width, and thickness of a metal fine line portion of a metal fine line network layer are 250 μm,20 μm, and 12 μm, respectively.

<Comparative Example 4>

A transparent conductive film according to Comparative Example 4 is a transparent conductive film according to Example 1 of Patent Document 7, and is a transparent conductive film in which a carbon nanotube layer is formed on a metal fine line network layer including silver. The pitch and width of a metal fine line portion of a metal fine line network layer are 300 $\mu$m and 10 $\mu$m, respectively.

<Comparative Example 5>

A transparent conductive film according to Comparative Example 5 is a transparent conductive film that includes only a metal fine line network layer including copper. The pitch, width, and thickness of a metal fine line portion of a metal fine line network layer are 300 $\mu$m, 9 $\mu$m, and 10 $\mu$m, respectively.

[Characteristics Evaluation for Transparent Conductive Film]

The light transmittance and sheet resistance of transparent conductive films according to Examples 1 to 3 and Comparative Examples 1 to 5 were measured. Table 1 shows the light transmittance and sheet resistance of the transparent conductive films. In Table 1, also the sheet resistance of a graphene layer in Examples 1 to 3, and the sheet resistance of an ITO layer in the transparent conductive films according to Comparative Examples 1 and 2 were described.

After measuring the light transmittance and sheet resistance, the corrosive properties of the transparent conductive films in an electrolyte solution were measured.
The electrolyte solution was prepared by dissolving 0.1 mol/l of sodium iodide (NaI), 1.4 mol/l of 1-propil-2,3-dimethylimidazolium iodide (DMPImI), 0.15 mol/l of iodine ($I_2$), and 0.2 mol/l of 4-tert-butylpyridine (TBP) in 2 g of methoxypropionitrile (MPM).

The transparent conductive films according to Examples 1 to 3 and Comparative Examples 1 to 5 were cut into a size of 2 cm x 2 cm, and immersed in 10ml of an electrolyte solution at room temperature for ten days. After being taken out from the electrolyte solution, the transparent conductive films were washed by water to be dried. After that, the transparent conductive films were observed under an optical microscope, and the corrosion of the metal fine line portion was evaluated. The result is shown in Table 1.

Table 1

| | Upper portion of transparent conductive film | | Metal fine line network layer | | | | Transparent conductive film | | Corrosion test | Comment |
|---|---|---|---|---|---|---|---|---|---|---|
| | Material | Sheet resistance Ω/sq) | Material | Pitch (μm) | Width of wiring (μm) | Thickness of wiring (μm) | Sheet resistance Ω/sq) | Transmittance (%) | | |
| Example 1 | Graphene | 200 | Cu | 300 | 9 | 10 | 0.03 | 85 | Not corroded | |
| Example 2 | Graphene | 200 | Cu | 600 | 9 | 10 | 0.06 | 87 | Not corroded | |
| Example 3 | Graphene | 200 | Cu | 250 | 20 | 12 | 0.01 | 76 | Not corroded | |
| Comparative example1 | ITO | 200 | Cu | 300 | 9 | 10 | 0.1 | 84 | Partly corroded | Example 1 of Patent Document 5 |
| Comparative example2 | ITO | 200 | Cu | 600 | 9 | 10 | 0.4 | 86 | Partly corroded | Example 2 of Patent Document 5 |
| Comparative example3 | ITO | - | Cu | 250 | 20 | 12 | 0.05 | 75 | Partly corroded | Example 1 of Patent Document 6 |
| Comparative example4 | CNT | - | Ag | 300 | 10 | - | 0.05 | 75 | Partly corroded | Example 1 of Patent Document 7 |
| Comparative example5 | Nothing | | Cu | 300 | 9 | 10 | 0.03 | 87 | Dissolved | |

As shown in Table 1, the sheet resistance of the transparent conductive films according to Examples 1 to 3 ranges from 0.01 Ω/sq to 0.06 Ω/sq, which is sufficiently low, i.e., equal to or smaller than that of Comparative Examples 1 to 5, and also the visible light transmittance of the transparent conductive films ranges from 76% to 87%, which is sufficiently high, i.e., equal to or higher than that of Comparative Examples 1 to 5. In addition, the transparent conductive films according to Comparative Examples 1 to 5 were partly corroded by the electrolyte solution, or were dissolved. On the other hand, the transparent conductive films according to Examples 1 to 3 were not corroded. That is, the transparent conductive films according to Examples 1 to 3 have not only excellent transparent conductivity but also high corrosion resistance to an electrolyte solution.

As described above, according to the first embodiment, a transparent conductive film has a structure in which the metal fine line network layers 12 are provided on the transparent substrate 11, and one or more layers of graphene layers 13 are provided thereon. Therefore, it is possible to achieve a transparent conductive film that has low sheet resistance, a high transmittance, and excellent corrosion resistance to an electrolyte solution. Moreover, the transparent conductive film is capable of securing conductivity on an entire surface thereof while keeping the aperture ratio of the metal fine line network layer 12 large. Moreover, the transparent conductive film can be easily produced at low costs by using a simple established existing technology, and it is possible to reduce the takt time. Moreover, by using a transparent plastic substrate as the transparent substrate 11, it is possible to easily achieve a flexible transparent conductive film. Furthermore, the graphene layer 13 that has excellent barrier properties is used for the transparent conductive film, which makes it possible to improve gas barrier properties with respect to water and the like.

<2. Second Embodiment>

[Transparent Conductive Film]

In a transparent conductive film according to a second embodiment, one or more layers of graphene layers 13 are provided on the transparent substrate 11, and the metal fine line network layers 12 are provided on the graphene layers 13. Other than that, it is the same as the transparent conductive film according to the first embodiment.

[Method of Producing Transparent Conductive Film]

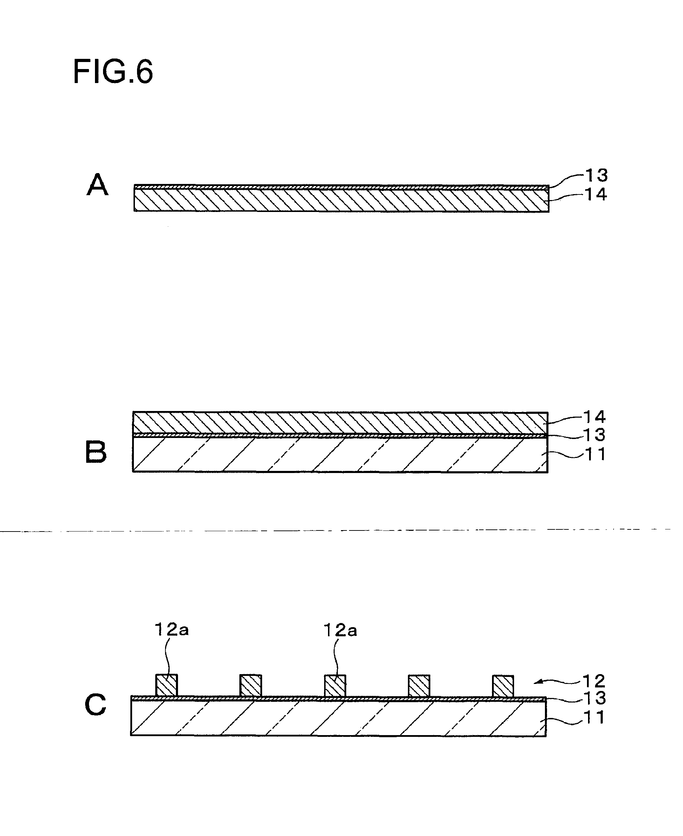

Figs. 6A to 6C show a method of producing the transparent conductive film.
As shown in Fig. 6A, similarly to the first embodiment, one or more layers of graphene layers 13 are formed on the first substrate 14.
Next, as shown in Fig. 6B, a side of the graphene layer 13 of the first substrate 14 is bonded to the transparent substrate 11.
Next, as shown in Fig. 6C, similarly to the second embodiment, the metal fine line network layer 12 is formed by etching the first substrate 14.
Accordingly, an intended transparent conductive film is produced.
According to the second embodiment, almost the same advantages as those of the first embodiment can be achieved.

<3. Third Embodiment>

[Transparent Conductive Film]

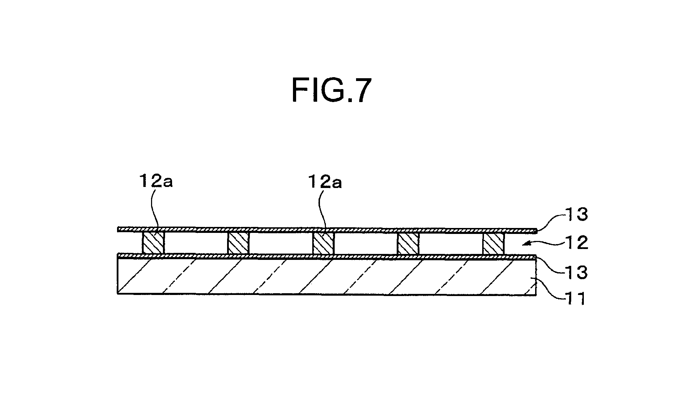

As shown in Fig. 7, in a transparent conductive film according to a third embodiment, one or more layers of graphene layers 13 are provided on the transparent substrate 11, the metal fine line network layers 12 are provided on the graphene layers 13, and one or more layers of graphene layers 13 are provided thereon. That is, in the transparent conductive film, the graphene layer 13 is provided on both surfaces of the metal fine line network layer 12. Other than that, it is the same as the transparent conductive film according to the first embodiment.

[Method of Producing Transparent Conductive Film]

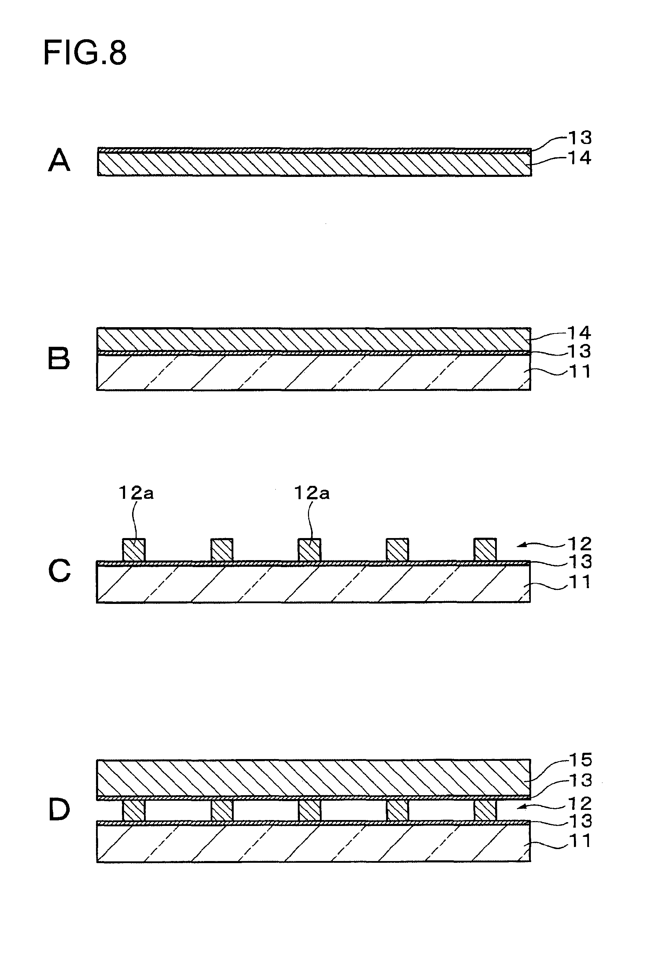

Figs. 8A to 8D show a method of producing the transparent conductive film.
As shown in Fig. 8A, similarly to the first embodiment, one or more layers of graphene layers 13 are formed on the first substrate 14.
Next, as shown in Fig. 8B, a side of the graphene layer 13 of the first substrate 14 is bonded to the transparent substrate 11.
Next, as shown in Fig. 8C, similarly to the second embodiment, the metal fine line network layer 12 is formed by etching the first substrate 14.

Next, similarly to the first embodiment, as shown in Fig. 3A, a side of the graphene layer 13, which is formed on the second substrate 15, is bonded to the metal fine line network layer 12.

Next, the second substrate15 is removed.

Accordingly, as shown in Fig. 7, an intended transparent conductive film is produced.

According to the third embodiment, the same advantages as those of the first embodiment can be achieved.

<4. Fourth Embodiment>

[Dye-Sensitized Photoelectric Conversion Apparatus]

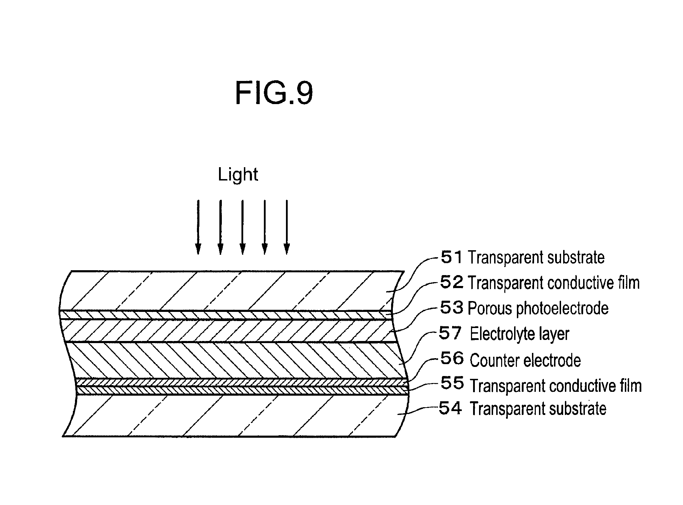

As shown in Fig. 9, in the dye-sensitized photoelectric conversion apparatus, a transparent conductive film 52 is provided on a transparent substrate 51, and a porous photoelectrode 53 is provided on the transparent conductive film 52. One or more types of photosensitizing dyes (not shown) are bonded to the porous photoelectrode 53. On the other hand, on a transparent substrate 54 being an opposing substrate, a transparent conductive film 55 is provided, and a counter electrode 56 is provided on the transparent conductive film 55. Then, an electrolyte layer 57 is filled between the porous photoelectrode 53 on the transparent substrate 51 and the counter electrode 56 on the transparent substrate 54, and the outer peripheral portion of the transparent substrate 51 and the transparent substrate 54 is sealed by a sealing member (not shown). Here, instead of the transparent substrate 54 and the transparent conductive film 55, a non-transparent substrate and a non-transparent conductive film may be used, respectively.

In the dye-sensitized photoelectric conversion apparatus, the transparent conductive film 52 and/or the transparent conductive film 55 include a transparent conductive film according to the first embodiment, which includes the metal fine line network layer 12 and the graphene layer 13. In this case, a side of the graphene layer 13 of the transparent conductive film faces the electrolyte layer 57. The transparent substrate 51 and the transparent conductive film 52 or the transparent substrate 54 and the transparent conductive film 55 may include a transparent conductive film having a structure in which the metal fine line network layers 12 are provided on the transparent substrate 11, and the graphene layers 13 is provided thereon, as a whole.

As the porous photoelectrode 53, typically, a porous semiconductor layer in which semiconductor particles are sintered is used. A photosensitizing dye is adsorbed on a surface of the semiconductor particles. As a material of the semiconductor particles, an elemental semiconductor typified by silicon, a compound semiconductor, a semiconductor having a perovskite structure, or the like can be used. These semiconductors are favorably an n-type semiconductor in which a conduction band electron becomes a carrier under light excitation to generate anode current. Specifically, a semiconductor such as titanium oxide ($TiO_2$), zinc oxide (ZnO), tungsten oxide ($WO_3$), niobium oxide ($Nb_2O_5$), strontium titanate ($SrTiO_3$), and tin oxide ($SnO_2$) is used. Among these semiconductors, $TiO_2$, especially, anatase $TiO_2$ is favorably used. It should be noted that the kind of the semiconductor is not limited to these, and two or more kinds of semiconductors are mixed or blended to be used as necessary. Moreover, the form of the semiconductor particles may be any one of a granular form, a tubular form, and a rod-like form.

The particle size of the semiconductor particles is not limited, but the average particle size of primary particles is favorably 1 to 200 nm, more favorably, 5 to 100 nm. Moreover, it is also possible to mix particles having a size greater than the semiconductor particles, and to improve the quantum yield by scattering incident light by the particles. In this case, the average size of the particles to be mixed separately is favorably 20 to 500 nm, but it is not limited to this.

The porous photoelectrode 53 favorably has a large actual surface area including a surface of particles that faces holes in a porous semiconductor layer including semiconductor particles so that as many photosensitizing dyes can be bonded thereto as possible. Therefore, the actual surface area in a state in which the porous photoelectrode 53 is formed on the transparent conductive film 52 is favorably 10 times or more, more favorably, 100 times or more, of the area of the outside (projected area) of the porous photoelectrode 53. This ratio is not particularly limited, but normally, it is about 1000 times.

In general, as the thickness of the porous photoelectrode 53 is increased and the number of semiconductor particles included per unit projected area is increased, the actual surface area is increased, and the amount of photosensitizing dyes that can be held per unit projected area is increased, so that the optical absorptance is increased. On the other hand, as the thickness of the porous photoelectrode 53 is increased, the distance over which the electrons transferred from the photosensitizing dye to the porous photoelectrode 53 diffuse until they reach the transparent conductive film 52 is increased, so that the loss of electrons due to recombination of electric charges in the porous photoelectrode 53 is also increased. Therefore, there exists a favorable thickness of the porous photoelectrode 53, but the thickness is generally 0.1 to 100 $\mu$m, more favorably, 1 to 50 $\mu$m, and particularly favorably, 3 to 30 $\mu$m.

Examples of the electrolyte solution constituting the electrolyte layer 57 include a solution that contains an oxidation-reduction system (redox pair). As the oxidation-reduction system, specifically, a combination of iodine ($I_2$) with an iodide salt of metal or an organic material, a combination of bromine ($Br_2$) with a bromide salt of metal or an organic material, or the like is used. Examples of cations constituting a metal salt include lithium ($Li^+$), sodium ($Na^+$), potassium

($K^+$), cesium ($Cs^+$), magnesium ($Mg^{2+}$), and calcium ($Ca^{2+}$). Moreover, favorable examples of cations constituting an organic salt include quaternary ammonium ions such as tetraalkylammonium ions, pyridinium ions, imidazolium ions, which may be used either singly or in combination of two or more of them.

As the electrolyte solution constituting the electrolyte layer 57, in addition to those described above, metal complexes such as a combination of a ferrocyanide with a ferricyanide, and a combination of ferrocene with ferricinium ion, sulfur compounds such as sodium polysulfide, and a combination of an alkylthiol with an alkyl disulfide, viologen dyes, a combination of hydroquinone with quinone, or the like may be used.

As the electrolyte of the electrolyte layer 57, among those described above, particularly, an electrolyte obtained by combining iodine ($I_2$) with lithium iodide (LiI), sodium iodide (NaI), or a quaternary ammonium compound such as imidazolium iodide is favorable. The concentration of an electrolyte salt is favorably 0.05 to 10 M, more favorably 0.2 to 3 M, based on the amount of the solvent. The concentration of iodine ($I_2$) or bromine ($Br_2$) is favorably 0.0005 to 1 M, more favorably 0.001 to 0.5 M.

The transparent substrates 51 and 54 are not particularly limited as long as they are formed of a material and have a shape, which permit easy transmission of light therethrough, and various substrate materials can be used. However, particularly, it is favorable to use a substrate material with a high visible light transmittance. Moreover, it is favorable to use a material which has high barrier performance of preventing moisture or gases from externally entering a dye-sensitized photoelectric conversion apparatus, and which has excellent solvent resistance and weather resistance. Specifically, examples of the material for the transparent substrates 51 and 54 include transparent inorganic materials such as quartz, and glass, and transparent plastics such as polyethylene terephthalate, polyethylene naphthalate, polycarbonate, polystyrene, polyethylene, polypropylene, polyphenylene sulfide, polyvinylidene difluoride, acetylcellulose, brominated phenoxy, aramids, polyimides, polystyrenes, polyarylates, polysulfones, polyolefins. The thickness of the transparent substrates 51 and 54 is not particularly limited, and can be appropriately selected, taking the light transmittance and the performance of blocking the inside and the outside of the photoelectric conversion apparatus into account.

The photosensitizing dye to be bonded to the porous photoelectrode 53 is not particularly limited, as long as it shows a sensitizing action. However, it is favorable for the photosensitizing dye to have an acid functional group that adsorbs on the surface of the porous photoelectrode 53. As the photosensitizing dye, in general, those which have a carboxyl group, a phosphate group or the like are favorable, and among those, the one which has a carboxyl group is more favorable. Specific examples of the photosensitizing dye include xanthene dyes such as rhodamine B, rose bengal, eosine, and erythrosine, cyanine dyes such as merocyanine, quinocyanine, and cryptocyanine, basic dyes such as phenosafranine, cabri blue, thiocine, and methylene blue, and porphyrin compounds such as chlorophyll, zinc porphyrin, and magnesium porphyrin. Other examples include azo dyes, phthalocyanine compounds, cumarin compounds, bipyridine complex compounds, anthraquinone dyes, and polycyclic quinone dyes. Among these, dyes which are complexes of at least one metal selected from a group consisting of Ru, Os, Ir, Pt, Co, Fe and Cu and in which the ligand includes a pyridine ring or an imidazolium ring are favorable because of their high quantum yields. In particular, dye molecules which have cis-bis(isothiocyanato)-N,N-bis(2,2'-dipyridyl-4,4'-dicarboxylic acid)- ruthenium(II) or tris(isothiocyanato)-ruthenium(II)-2,2':6',2''-terpyridine-4,4',4''-tricarboxylic acid as a basic skeleton are favorable because of their wide absorption wavelength regions. It should be noted that the photosensitizing dye is not limited to these. As the photosensitizing dyes, typically, one of these is used. However, two or more of the photosensitizing dyes may also be used in combination. In a case where two or more photosensitizing dyes are used in combination, the photosensitizing dyes favorably include an inorganic complex dye which is held on the porous photoelectrode 53 and which has a property of bringing about MLCT (Metal to Ligand Charge Transfer), and an organic molecule dye which is held on the porous photoelectrode 53 and which has a property of intramolecular CT (Charge Transfer). In this case, the inorganic complex dye and the organic molecule dye are adsorbed on the porous photoelectrode 53 in different conformations. The inorganic complex dye favorably has a carboxyl group or a phosphono group as a functional group bonding to the porous photoelectrode 53. Moreover, the organic molecule dye favorably has both a carboxyl group or a phosphono group and a cyano group, an amino group, a thiol group or a thione group, on the same carbon atom, as the functional groups bonding to the porous photoelectrode 53. The inorganic complex dye is, for example, a polypyridine complex. The organic molecule dye is, for example, an aromatic polycyclic conjugated molecule which has both an electron donative group and an electron acceptive group and which has a property of intramolecular CT.

The method of adsorbing the photosensitizing dye onto the porous photoelectrode 53 is not particularly limited. However, the above-mentioned photosensitizing dye can be dissolved in a solvent such as alcohols, nitriles, nitromethane, halogenated hydrocarbons, ethers, dimethyl sulfoxide, amides, N-methylpyrrolidone, 1,3-dimethylimidazolidinone, 3-methyloxazolidinone, esters, carbonic acid esters, ketones, hydrocarbons, and water, and then the porous photoelectrode 53 can be immersed therein, or a solution containing the photosensitizing dye can be applied onto the porous photoelectrode 53. Moreover, deoxycholic acid or the like may be added for the purpose of suppressing association between molecules of the photosensitizing dye. If necessary, a UV absorber may be used jointly.

After the photosensitizing dye is adsorbed on the porous photoelectrode 53, the surface of the photoelectrode 53 may be processed by using an amine, for the purpose of facilitating the removal of the photosensitizing dye adsorbed in excess. Examples of the amine include pyridine, 4-tert-butylpyridine, and polyvinylpyridine. In a case where these are liquid, they may be used as they are, or may be used after being dissolved in an organic solvent.

As the material of the counter electrode 56, any material may be used as long as it is a conductive material. However, if a conductive layer is formed on a side that faces the electrolyte layer 57 including an insulation material, this may also be used. As the material of the counter electrode 56, a material that is electrochemically stable is favorably used. Specifically, platinum, gold, carbon, a conductive polymer, or the like is desirably used.

Moreover, in order to enhance the catalytic activity for the reduction reaction at the counter electrode 56, the surface of the counter electrode 56, which is in contact with the electrolyte layer 57, is favorably formed so that a microstructure is formed and the actual surface area is increased. For example, if the surface of the counter electrode 56 includes platinum, it is favorably formed in the form of platinum black, and if it includes carbon, it is favorably formed in the form of porous carbon. The platinum black may be formed by using an anodic oxidation method for platinum, platinum chloride treatment, or the like, and the porous carbon may be formed by using a method such as sintering of carbon particles and burning of an organic polymer.

As the material of the sealing member, a material that has light resistance, insulating properties, moistureproof properties, and the like, is favorably used. Specific examples of the material of the sealing material include epoxy resin, UV curable resin, acrylic resin, polyisobutylene resin, EVA (ethylene-vinyl acetate), ionomer resin, ceramics, and various thermal adhesive films.

Moreover, in a case where an electrolyte solution is filled to form the electrolyte layer 57, an inlet is required. The location of the inlet is not particularly limited as long as it is not provided on the porous photoelectrode 53 or on the area of the counter electrode 56 opposed to the porous photoelectrode 53. Moreover, the method of filling the electrolyte solution is not particularly limited. However, the method of filling the electrolyte solution into the photoelectric conversion apparatus under reduced pressure with its outer periphery sealed in advance and its inlet left open is favorable. In this case, the method of dripping a few drops of the solution into the inlet and filling the solution by capillary action is convenient. Moreover, the solution may be filled under reduced pressure or heat as necessary. After the solution is completely filled, the solution remaining on the inlet is removed and the inlet is sealed. The sealing method is not particularly limited either. However, if necessary, it may be sealed by attaching a glass plate or plastic substrate with a sealing agent. Moreover, in addition to the method, it may be sealed by dripping the electrolyte solution onto the substrate and attaching the substrate under reduced pressure as in the ODF (One Drop Filling) process to fill liquid crystal into liquid crystal panels. It is also possible to apply heat or pressure as necessary so as to ensure that the electrolyte solution is sufficiently impregnated into the porous photoelectrode 53 after the sealing.

[Method of Producing Dye-Sensitized Photoelectric Conversion Apparatus]

Next, a method of producing the dye-sensitized photoelectric conversion apparatus will be described. First, the porous photoelectrode 53 is formed on the transparent conductive film 52 that is formed on the transparent substrate 51. The method of forming the porous photoelectrode 53 is not particularly limited. Taking physical properties, convenience, production cost, and the like into consideration, however, it is favorable to use a wet film forming method. A favorable example of the wet film forming method is a method in which a powder or sol of semiconductor particles is uniformly dispersed in a solvent such as water to prepare a pasty dispersion, and the dispersion is applied or printed onto the transparent conductive film 52 of the transparent substrate 51. The application method or the printing method for the dispersion is not particularly limited, and known methods can be used. Specifically, as the application method, for example, a dipping method, a spraying method, a wire bar method, a spin coating method, a roller coating method, a blade coating method, and a gravure coating method may be used. Moreover, as the printing method, a relief printing method, an offset printing method, a gravure printing method, an intaglio printing method, a rubber plate printing method, a screen printing method, or the like may be used.

In a case where anatase $TiO_2$ is used as the material of the semiconductor particles, the anatase $TiO_2$ may be a marketed product in the form of powder, sol, or slurry, or may be formed to have a predetermined particle diameter by a known method such as a method in which a titanium oxide alkoxide is hydrolyzed. In case of using a commercialized powder, it is favorable to eliminate the secondary agglomeration of particles, and to pulverize the particles by using a mortar, a ball mill, or the like, at the time of preparing the pasty dispersion. At this time, in order to prevent the particles, which are released from secondary agglomeration, from agglomerating again, acetylacetone, hydrochloric acid, nitric acid, a surfactant, a chelate agent, or the like may be added to the pasty dispersion. Moreover, in order to increase the viscosity of the pasty dispersion, polymers such as polyethylene oxide and polyvinyl alcohol, or various thickeners such as cellulose thickeners may be added to the pasty dispersion.

After the semiconductor particles are applied or printed onto the transparent conductive film 52, the porous photoelectrode 53 is favorably burned in order to electrically connect the semiconductor particles with each other, to enhance the mechanical strength of the porous photoelectrode 53, and to enhance the adhesion of the porous photoelectrode 53 to the transparent conductive film 52. The range of the burning temperature is not particularly limited. If the temperature is too high, however, the electrical resistance of the transparent conductive film 52 becomes high, and the transparent conductive film 52 may be melted. Therefore, normally, the burning temperature is favorably 40 to 700°C, more favorably, 40 to 650°C. Moreover, the burning time also is not particularly limited. However, the burning time is normally about 10 minutes to about 10 hours. In view of performing burning, as the transparent substrate 51 forming the transparent conductive film 52, favorably, a quartz substrate, a glass substrate, or the like, which has sufficient heat resistance, is used.

Next, the photosensitizing dyes is bonded to the porous photoelectrode 53 by immersing the transparent substrate 51 on which the porous photoelectrode 53 is formed in a solution obtained by dissolving the photosensitizing dye in a predetermined solvent.

On the other hand, the counter electrode 56 is formed by a sputtering method or the like, on the transparent conductive film 55 that is formed on the transparent substrate 54.

Next, the transparent substrate 51 and the transparent 54 are arranged so that the porous photoelectrode 53 and the counter electrode 56 face each other at a predetermined interval of, for example, 1 to 100 $\mu$m, favorably, 1 to 50 $\mu$m. Then, a sealing member (not shown) is formed on the outer peripheral portion of the transparent substrate 51 and the transparent substrate 54 to make space in which the electrolyte layer 57 is included. The electrolyte solution is filled in the space through, for example, an inlet (not shown) formed on the transparent substrate 51 in advance to form the electrolyte layer 57. After that, the inlet is sealed.

Accordingly, an intended dye-sensitized photoelectric conversion apparatus is produced.

[Operation of Dye-Sensitized Photoelectric Conversion Apparatus]

Next, the operation of the dye-sensitized photoelectric conversion apparatus will be described.

The dye-sensitized photoelectric conversion apparatus, upon incidence of light thereon, operates as a cell with the counter electrode 56 as a positive electrode and with the transparent conductive film 52 as a negative electrode. The principle of this operation is as follows. It should be noted that, here, it is assumed that $TiO_2$ is used as the material of the porous photoelectrode 53, and an oxidation-reduction species of $I^-/I_3^-$ is used as the redox pair, but the assumption is not limited to this. Moreover, it is assumed that one kind of photosensitizing dye is bonded to the porous photoelectrode 53.

When photons transmitted through the transparent substrate 51 and the transparent conductive film 52 to be incident on the porous photoelectrode 53 are absorbed by the photosensitizing dye bonded to the porous photoelectrode 53, electrons in the photosensitizing dye are excited from a ground state (HOMO) to an excited state (LUMO). The electrons thus excited are drawn through the electrical coupling between the photosensitizing dye and the porous photoelectrode 53 into the conduction band of $TiO_2$ constituting the porous photoelectrode 53, and passes through the porous photoelectrode 53 to reach the transparent conductive film 52.

On the other hand, the photosensitizing dye having lost the electrons accepts electrons from a reducing agent in the electrolyte layer 57, e.g., $I^-$, by the following reaction, to produce an oxidizing agent, e.g., $I_3^-$ (combined ion of $I_2$ and $I^-$), in the electrolyte layer 57.

$$2I^- \rightarrow I_2 + 2e^-$$

$$I_2 + I^- \rightarrow I_3^-$$

The oxidizing agent thus produced diffuses to reach the counter electrode 56, and accepts electrons from the counter electrode 56 by the reverse reaction of the above-mentioned reaction, to be thereby reduced to the original reducing agent.

$$I_3^- \rightarrow I_2 + I^-$$

$$I_2 + 2e^- \rightarrow 2I^-$$

The electrons sent out from the transparent conductive film 52 into an external circuit performs an electrical work in the external circuit, before returning to the counter electrode 56. In this way, optical energy is converted into electrical energy without leaving any change in the photosensitizing dye or the electrolyte layer 57.

According to the second embodiment, by using the transparent conductive film according to the first embodiment as the transparent conductive film 52 or the transparent conductive film 55, the transparent conductive film 52 or the transparent conductive film 55 can have low sheet resistance and a high light transmittance. In addition, a side of the graphene layer 13 of the metal fine line network 12 and the graphene layer 13 constituting the transparent conductive film faces a side of the electrolyte layer 57, which can improve the corrosion resistance to an electrolyte solution of the transparent conductive film 52 or the transparent conductive film 55. Moreover, in a case where the transparent conductive film according to the first embodiment is used as the transparent conductive film 52, it is possible to prevent, by the graphene layer 13, metal from migrating from the metal fine line portion 12a of the metal fine line network layer 12 to the porous photoelectrode 53. Accordingly, it is possible to achieve a long-lived dye-sensitized photoelectric conversion apparatus with high performance at low costs.

Although embodiments and examples according to the present technology have been described specifically, the present technology is not limited to the above-mentioned embodiments and examples, and can be variously modified based on the technical idea of the present technology.

For example, a numerical value, a structure, a configuration, a shape, a material, and the like described in the above-mentioned embodiments and examples are only examples, and a numerical value, a structure, a configuration, a shape, a material, and the like different from those may be used as necessary.

Description of Reference Numerals

| | |
|---|---|
| 11 | transparent substrate |
| 12 | metal fine line network layer |
| 13 | graphene layer |
| 14 | first substrate |
| 15 | second substrate |
| 16 | etching protection film |
| 51 | transparent substrate |
| 52 | transparent conductive film |
| 53 | porous photoelectrode |
| 54 | transparent substrate |
| 55 | transparent conductive film |
| 56 | counter electrode |
| 57 | electrolyte layer |

**Claims**

1. A transparent conductive film, comprising:

   a metal fine line network layer; and
   one or more layers of graphene layers provided on at least one surface of the metal fine line network layer.

2. The transparent conductive film according to claim 1, wherein
   the metal fine line network layer is provided on a transparent substrate, and the graphene layer is provided on the metal fine line network layer.

3. The transparent conductive film according to claim 2, wherein
   the metal fine line network layer includes at least one metal selected from a group consisting of copper, silver, aluminum, gold, iron, nickel, titanium, and platinum.

4. The transparent conductive film according to claim 3, wherein
   sheet resistance of the transparent conductive film is equal to or higher than 0.01 $\Omega$/sq and equal to or less than 10 $\Omega$/sq.

5. The transparent conductive film according to claim 4, wherein
   a light transmittance of the transparent conductive film at a wavelength of 550 nm is equal to or greater than 70%.

6. The transparent conductive film according to claim 5, wherein
   smoothness of a conductive surface of the transparent conductive film is greater than 5 $\mu$m.

7. The transparent conductive film according to claim 2, wherein
   the transparent substrate is a plastic substrate.

8. The transparent conductive film according to claim 1, wherein
   on both surfaces of the metal fine line network layer, the graphene layer is provided.

9. The transparent conductive film according to claim 1, wherein
   a surface of the metal fine line network layer is blackened.

10. The transparent conductive film according to claim 1, wherein
    the graphene layer is provided on a transparent substrate, and the metal fine line network layer is provided on the graphene layer.

11. A method of producing a transparent·conductive film, the method comprising the steps of:

    forming one or more layers of graphene layers on a first substrate including metal;
    bonding a side of the graphene layer of the first substrate to a second substrate;
    removing the first substrate;
    bonding a side of the graphene layer of the second substrate to a metal fine line network layer formed on a transparent substrate; and
    removing the second substrate.

12. The method of producing a transparent conductive film according to claim 11, wherein
    on the transparent substrate, one or more layers of graphene layers are formed, and the metal fine line network layer is formed on the graphene layer.

13. The method of producing a transparent conductive film according to claim 11, wherein
    the first substrate includes at least one metal selected from a group consisting of aluminum, silicon, titanium, vanadium, chromium, manganese, iron, cobalt, nickel, copper, molybdenum, platinum, silver, gold, and tungsten.

14. A method of producing a transparent conductive film, the method comprising the steps of:

    forming one or more layers of graphene layers on a first substrate including metal;
    bonding a side of the graphene layer of the first substrate to a second substrate;
    forming a metal fine line network layer by patterning the first substrate;
    bonding a side of the metal fine line network layer of the second substrate to a transparent substrate; and
    removing the second substrate.

15. A method of producing a transparent conductive film, the method comprising the steps of:

    forming one or more layers of graphene layers on a first substrate including metal;
    bonding a side of the graphene layer of the first substrate to a metal fine line network layer formed on a transparent substrate; and
    removing the first substrate.

16. A method of producing a transparent conductive film, the method comprising the steps of:

    forming one or more layers of graphene layers on a first substrate including metal;
    bonding a side of the graphene layer of the first substrate to a transparent substrate; and
    forming a metal fine line network layer by patterning the first substrate.

17. The method of producing a transparent conductive film according to claim 16, further comprising:

    bonding one or more layers of graphene layers formed on a second substrate to the metal fine line network layer after forming the metal fine line network layer; and
    removing the second substrate.

18. A photoelectric conversion apparatus having a structure in which an electrolyte layer is filled between a porous photoelectrode and a counter electrode provided on a transparent substrate through a transparent conductive film, the transparent conductive film including a metal fine line network layer and one or more layers of graphene layers provided on at least one surface of the metal fine line network layer.

19. The photoelectric conversion apparatus according to claim 18, wherein
the counter electrode is provided on a transparent substrate through a transparent conductive film, and the transparent conductive film includes a metal fine line network layer and one or more layers of graphene layers provided on at least one surface of the metal fine line network layer.

20. An electronic apparatus, comprising
a transparent conductive film including
a metal fine line network layer, and
one or more layers of graphene layers provided on at least one surface of the metal fine line network layer.

# FIG.1

Metal fine line portion

12a      12a

Graphene layer
13
12
Metal fine line network layer
11
Transparent substrate

A

12a        12a

12

11

B

# FIG.2

A

First substrate
14

B

13
14

C

Second substrate
15
13
14

# FIG.3

A

15
13

B

15
13
12
11

12a                    12a

# FIG.4

A — 15, 13, 14, 16

B — 15, 13, 12

C — 15, 13, 12, 11

FIG.5

A

13
14

B

14
13
12
11

12a            12a

# FIG.6

A
— 13
— 14

B
— 14
— 13
— 11

12a          12a

C
— 12
— 13
— 11

# FIG.7

12a    12a    13    12    13    11

# FIG.8

A

B

C

D

# FIG.9

Light

51 Transparent substrate
52 Transparent conductive film
53 Porous photoelectrode
57 Electrolyte layer
56 Counter electrode
55 Transparent conductive film
54 Transparent substrate

# FIG.10

A

102      103      102

103
103
101

B

202        202

203

201

C

302        302

303
301

D

401a   402     402   401a

403
401

E

502   503   502

504
503
501

Related art

## INTERNATIONAL SEARCH REPORT

| International application No. |
| --- |
| PCT/JP2011/005646 |

A.  CLASSIFICATION OF SUBJECT MATTER
*H01B5/14*(2006.01)i, *H01B13/00*(2006.01)i, *H01L31/04*(2006.01)i, *H01M14/00*(2006.01)i

According to International Patent Classification (IPC) or to both national classification and IPC

B.  FIELDS SEARCHED

Minimum documentation searched (classification system followed by classification symbols)
H01B5/14, H01B13/00, H01L31/04, H01M14/00

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>A | JP 2009-252493 A  (Konica Minolta Holdings, Inc.),<br>29 October 2009 (29.10.2009),<br>claims; paragraphs [0024] to [0041]<br>(Family: none) | 1-7,18-20<br>8-17 |
| A | JP 2009-21129 A  (Fujikura Ltd.),<br>29 January 2009 (29.01.2009),<br>claims; paragraph [0021]; fig. 1<br>(Family: none) | 1-20 |
| A | JP 2007-287478 A  (Mitsubishi Gas Chemical Co., Inc.),<br>01 November 2007 (01.11.2007),<br>claims<br>(Family: none) | 1-20 |

☐  Further documents are listed in the continuation of Box C.      ☐  See patent family annex.

| | |
| --- | --- |
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>27 October, 2011 (27.10.11) | Date of mailing of the international search report<br>08 November, 2011 (08.11.11) |
| --- | --- |
| Name and mailing address of the ISA/<br>Japanese Patent Office | Authorized officer |
| Facsimile No. | Telephone No. |

Form PCT/ISA/210 (second sheet) (July 2009)

**EP 2 634 777 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009004726 A
- JP 2009252493 A
- JP 2009231194 A
- JP 2009021342 A
- JP 2005108467 A
- JP 2005332705 A
- JP 2008288102 A

### Non-patent literature cited in the description

- *Nano Letters,* 2009, vol. 9, 4359